# EUROPÄISCHE PATENTSCHRIFT

(11) **EP 0 837 002 B1**
(45) Veröffentlichungstag und Bekanntmachung des Hinweises auf die Patenterteilung: **03.04.2002**
(21) Anmeldenummer: 96116750.9
(22) Anmeldetag: 18.10.1996
(51) Int. Cl.: B65D 1/00, H05K 5/06, B65D 41/04

(54) **Gehäuse für industrielle Anwendungen**
Casing for industrial uses
Boîtier à applications industrielles

(43) Veröffentlichungstag der Anmeldung: 22.04.1998
(73) Patentinhaber: Endress + Hauser GmbH + Co., 79689 Maulburg (DE)
(72) Erfinder: Rottmar, Werner, 79585 Steinen (DE); Alznauer, Miroslaw, 79697 Wies (DE)

(56) Entgegenhaltungen:
- DE-U- 8 913 858
- GB-A- 374 702
- NL-A- 294 044
- US-A- 2 847 498
- US-A- 3 286 868

## Beschreibung

Die Erfindung betrifft ein Gehäuse für industrielle Anwendungen mit einem Gehäusetopf und einem abnehmbaren Deckel.

Gehäuse für industrielle Anwendungen sind beispielsweise Gehäuse zur Aufnahme der Elektronik eines Meßgeräts, z.B. eines Druck-, Füllstands- oder Durchflußmeßgeräts. Solche Gehäuse weisen abnehmbare Deckel auf, z.B. damit die Elektronik für eine Einstellung oder Parametrierung derselben am Meßort zugänglich ist.

Damit derartige Gehäuse in der Lebensmittelindustrie eingesetzt werden dürfen, müssen sie besonderen Auflagen genügen. Hierzu gehören Anforderungen an die Hygiene, wonach alle lebensmittel-berührten Dichtungen austauschbar sein müssen, die Gehäuse gründlich reinigbar zu sein haben und die Gehäuse möglichst keine Hinterschneidungen aufweisen, in denen sich Ansatz ablagern kann. Zusätzlich muß die Dichtheit des Gehäuses bei Langzeiteinsätzen sichergestellt sein. Dies muß auch dann gewährleistet sein, wenn es regelmäßig z.B. mittels eines in der Lebensmittelindustrie verwendeten Hochdruck-Dampfstrahlers gereinigt wird. Vergleichbare Anforderungen werden von der Pharmazeutischen Industrie gestellt.

Gehäuse für industrielle Anwendungen müssen außerdem korosionsbständig und chemisch beständig sein.

Auf dem Markt sind Gehäuse erhältlich, bei denen ein Deckel mittels eines mehrgängigen Gewindes auf einen Gehäusetopf geschraubt ist. Deckel und Gehäusetopf sind üblicherweise Gußteile aus Aluminium oder Edelstahl. Solche Bauteile sind teuer. Bedingt durch die Gewinde müssen diese Gehäuse eine Wandstärke von etwa vier Milimetern aufweisen, damit eine ausreichende mechanische Stabilität gewährleistet ist.

Diese Wandstärke bedingt einen Mindestmaterialaufwand und damit ein Mindestgewicht der Gehäuse.

Document US-A-3 286 868 beschreibt ein Gehäuse, von dem sich die Gegenstände der Ansprüche 1 und 2 dadurch unterscheiden, dass sie jeweils mindestens drei sichenpaare definieren.

Es ist eine Aufgabe der Erfindung, ein Gehäuse für industrielle Anwendungen mit einem Gehäusetopf und einem abnehmbaren Deckel anzugeben, das in der Lebensmittelindustrie einsetzbar ist, das robust und dicht ist und das kostengünstig herstellbar ist.

Hierzu besteht die Erfindung in einem Gehäuse nach Anspruch 1.

Weiterhin besteht die Erfindung in einem Gehäuse nach Auspruch 2.

Gemäß einer Ausgestaltung der Erfindung weist der Absatz eine an den zweiten Abschnitt des Gehäusetopfes angrenzende Mantelfläche und eine umlaufende an den ersten Abschnitt angrenzende Nut auf.

Gemäß einer anderen Ausgestaltung der Erfindung weist der Absatz eine zwischen dem ersten und dem zweiten Abschnitt des Gehäusetopfes angeordnete Mantelfläche auf und der Deckel weist an dessen gehäusetopf-zugewandter Seite einen Bereich mit einem Durchmesser auf, der geringfügig größer ist als der Durchmesser des daran anschließenden Abschnitts des Deckels.

Gemäß einer Weiterbildung der Erfindung ist die Dichtung eine Formdichtung, die einen Ring mit ringförmigem Querschnitt und eine daran angeformte Ringscheibe mit rechteckigen Querschnitt aufweist und die Ringscheibe liegt mit einer Ringfläche auf dem Absatz.

Gemäß einer Weiterbildung der Erfindung liegt der Deckel mit einer ringförmigen Stirnfläche auf einer gehäusetopf-abgewandten Ringfläche der Ringscheibe auf.

Gemäß einer Ausgestaltung der Erfindung sind die spitzen Winkel kleiner oder gleich 7°.

Gemäß einer Ausgestaltung der Erfindung sind die Sicken spitzwinklige Kreisringsegmente. Die Sicken eines Sickenpaares weisen die gleiche Länge auf und sind zueinander parallel und gegeneinander parallel zu deren Längsachse versetzt angeordnet.

Gemäß einer Ausgestaltung der Erfindung ist in dem Gehäuse eine Elektronik eines Meßgeräts angeordnet.

Gemäß einer Ausgestaltung der Erfindung ist das Gehäuse mittels Umformtechnik, insb. aus einem Edelstahlblech, hergestellt.

Die Erfindung und deren Vorteile werden nun anhand der Figuren der Zeichnung, in denen zwei Ausführungsbeispiele dargestellt sind, näher erläutert; gleiche Elemente sind in den Figuren mit gleichen Bezugszeichen versehen.
- Fig. 1: zeigt eine teilweise geschnittene Ansicht eines Deckels eines ersten Ausführungsbeispiels;
- Fig. 2: zeigt eine Ansicht eines Gehäusetopfs des ersten Ausführungsbeispiels;
- Fig. 3: zeigt im Längsschnitt eine zwischen dem Deckel und dem Gehäusetopf eingespannte Dichtung des ersten Ausführungsbeispiels;
- Fig. 4: zeigt eine Draufsicht auf den in Fig. 1 dargestellten Deckel;
- Fig. 5: zeigt eine Draufsicht auf den in Fig. 2 dargestellten Gehäusetopf;
- Fig. 6: zeigt eine teilweise geschnittene Ansicht eines Gehäuses eines zweiten Ausführungsbeispiels und
- Fig. 7: zeigt im Längsschnitt eine zwischen dem Deckel und dem Gehäusetopf eingespannte Dichtung des zweiten Ausführungsbeispiels;

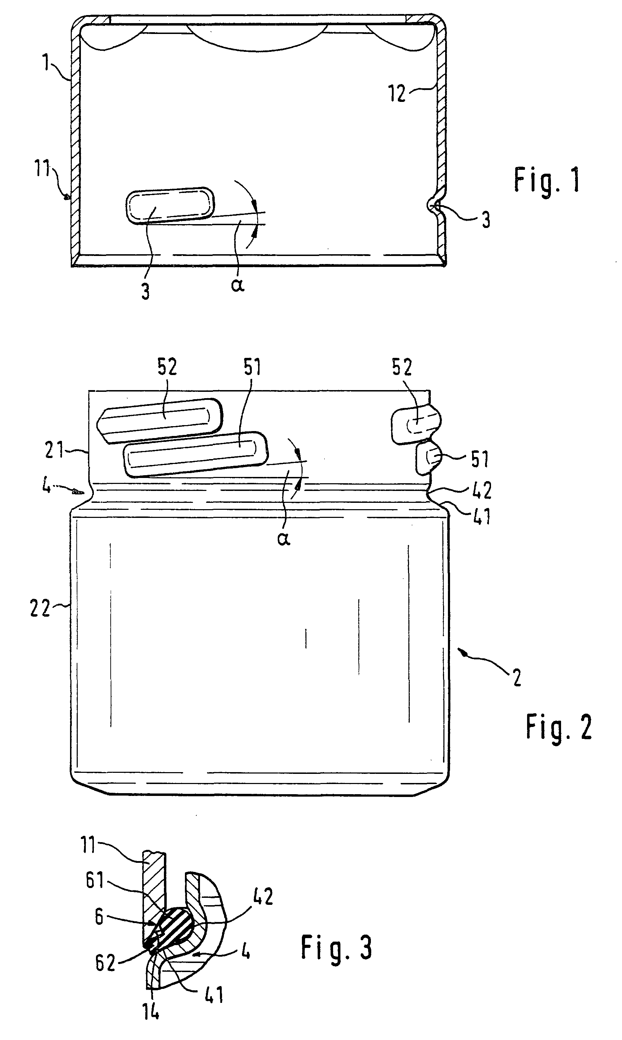

Die Figuren 1 bis 5 zeigen ein erstes Ausführungsbeispiel eines erfindungsgemäßen Gehäuses. Das Gehäuse weist einen in Fig. 1 dargestellten Deckel 1 und einen in Fig. 2 dargestellten Gehäusetopf 2 auf.

Das Gehäuse besteht aus Edelstahl. Edelstahl zeichnet sich durch Korosionsbeständigkeit, chemische Beständigkeit und mechanische Festigkeit aus.

Der Deckel 1 ist topfartig. Er hat die Form eines einseitig endseitig verschlossenen Hohlzylinders und weist einen zylindrischen Bereich 11 auf.

An diesem zylindrischen Bereich 11 sind bei dem in Fig. 1 gezeigten Ausführungsbeispiel drei in das Innere des Deckels 1 gewölbte Sicken 3 angeordnet. Diese befinden sich innerhalb des Deckels 1 auf gleicher Höhe.

Die Sicken 3 sind abgerundet, damit in den entsprechenden Einbuchtungen auf der Außenseite des Deckels 1 keine Ansatzbildung erfolgt.

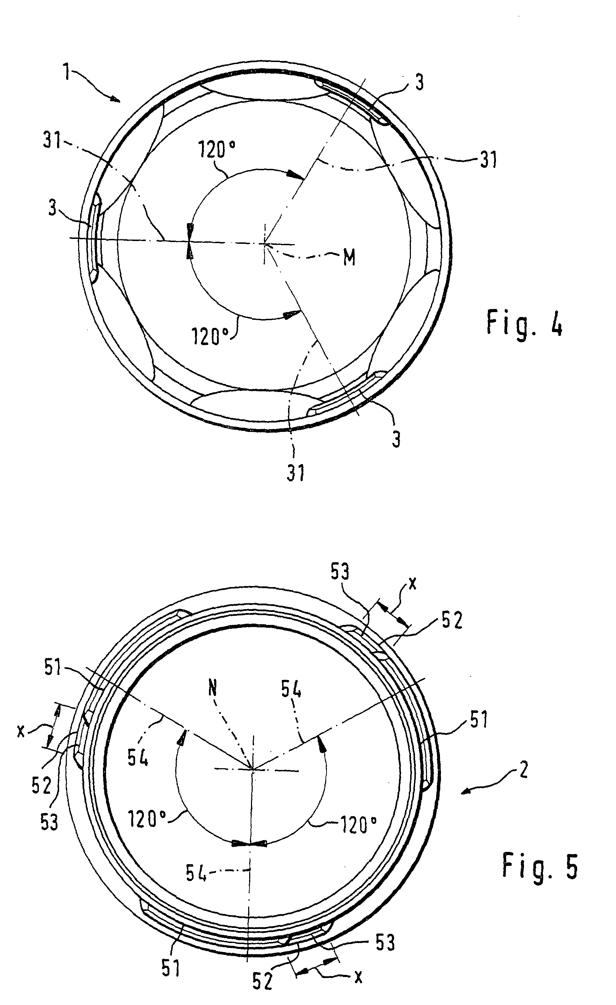

Fig. 1 zeigt eine teilweise geschnitttene Ansicht des Deckels 1 und Fig. 4 eine Draufsicht. Die Sicken 3 weisen jeweils die Form eines spitzwinkligen Kreisringsegments auf. Die Abstände zwischen zwei benachbarten Sicken 3 sind jeweils gleich. In der Draufsicht von Fig. 4 schließen einander benachbarte Verbindungslinien 31 zwischen dem geometrischen Schwerpunkt der jeweiligen Sicke 3 und dem Mittelpunkt M des zylindrischen Bereichs 11 jeweils einen Winkel von 120° ein. Wie in Fig. 1 dargestellt, sind die Sicken 3 gegenüber einer Senkrechten auf die Längsachse des Deckels 1 um einen spitzen Winkel α geneigt.

Der in Fig. 2 dargestellte Gehäusetopf 2 weist einen zylindrischen ersten Abschnitt 21 und einen daran angrenzenden zweiten Abschnitt 22 auf. Der zweite Abschnitt 22 ist in dem dargestellten Ausführungsbeispiel ebenfalls zylindrisch. Zwischen dem ersten und dem zweiten Abschnitt 21, 22 besteht ein Absatz 4, der dadurch bedingt ist, daß der erste Abschnitt 21 einen einen geringeren Außendurchmesser aufweist als der zweite Abschnitt 22. Im Bereich dieses Absatzes 4 nimmt der Außendurchmesser des Gehäusetopfes kontinuierlich in von dem zweiten Abschnitt 22 abgewandter Richtung ab. Der Absatz 4 weist daher eine konische Mantelfläche 41 auf.

Mit dem ersten Abschnitt 21 ist der Deckel 1 lösbar zu verbinden. Hierzu sind am ersten Abschnitt 21 auf gleicher Höhe drei nach außen gewölbte Sickenpaare angeordnet. Fig. 5 zeigt eine Draufsicht auf den Gehäusetopf 2 von der dem zweiten Abschnitt 22 abgewandten Seite her gesehen. Die Abstände zwischen zwei benachbarten Sickenpaaren sind jeweils gleich. Zueinander benachbarte Verbindungslinien 54 zwischen dem geometrischen Schwerpunkt der jeweiligen Sickenpaare und dem Mittelpunkt N des zylindrischen ersten Abschnitts 21 schließen jeweils einen Winkel von 120° ein.

Wie in Fig. 2 dargestellt, weist jedes Sickenpaar eine erste Sicke 51 und eine zweite Sicke 52 auf. Die erste Sicke 51 verläuft jeweils parallel zu der zweiten Sicke 52 und beide Sicken 51, 52 sind gegenüber einer Senkrechten auf die Längsachse des ersten Abschnitts 21 um einen spitzen Winkel α geneigt. Sie weisen alle jeweils die Form eines spitzwinkligen Kreisringsegments auf und haben alle die gleiche Länge. Die erste und die zweite Sicke 51, 52 sind parallel zueinander. Sie sind gegeneinander parallel zu deren Längsachse versetzt angeordnet. Die Enden der Sicken 51, 52 eines Sickenpaares sind somit in der Draufsicht von Fig. 5 einen Abstand x voneinander entfernt angeordnet. Die Draufsicht erfolgt von der dem zweiten Abschnitt 22 abgewandten Seite her. Folglich ist ein Abschnitt 53 der unteren, d.h. der dem zweiten Abschnitt 22 zugewandt angeordneten Sicke 51 nicht durch die obere, d.h. die dem zweiten Abschnitt 22 abgewandt angeordneten Sicke 52, überdeckt.

Vor dem Schließen des Gehäuses ist auf den Absatz 4 eine ringförmige Dichtung 6 aufzulegen. Der Innendurchmesser der Dichtung 6 ist vorzugsweise geringfügig kleiner als der Außendurchmesser des Absatzes 4 auf dem sie liegt. Die Dichtung 6 ist dadurch auf den Absatz 4 gespannt und somit in ihrer Lage fixiert.

Die Dichtung 6 ist vorzugsweise eine Formdichtung aus einem Elastomer z.B. einen Silikonkautschuk oder einem Neoprenkautschuk.

Fig. 3 zeigt die Dichtung 6 im eingespannten Zustand. Sie weist einen Ring 61 mit einem ringförmigem Querschnitt auf. An diesen ist eine Ringscheibe 62 mit rechteckigen Querschnitt angeformt. Die Dichtung 6 liegt mit einer Ringfläche der Ringscheibe 62 auf der konischen Mantelfläche 41.

Der Deckel 1 ist auf den Gehäusetopf 2 so aufzusetzen, daß die Sicken 3 jeweils mit einem Endbreich auf den nicht durch die zweiten Sicken 52 überdeckten Abschnitten 53 der unteren Sicke 52 aufliegen. Dadurch das drei Sicken 3 und drei Sickenpaare eingesetzt sind, ist ein Verkippen oder Verkanten des Deckels 1 ausgeschlossen. Eine auf den Deckel 1 in axialer gehäusetopf-zugewandter Richtung einwirkende Kraft wird gleichmäßig verteilt. Gleichzeitig wird der Deckel 1 zentriert.

Ein gehäusetopf-zugewandter Abschnitt des zylindrischen Bereichs 11 des Deckels 1 umgreift den zylindrischen ersten Abschnitt 21 des Gehäusetopfs 2. Die Dichtung 6 wird bereits beim Aufdrücken des Deckels 1 wirksam, da der gehäusetopf-zugewandte Abschnitt des zylindrischen Bereichs 11 hierbei über den Ring 61 hinweggeschoben wird. Der Ring 61 ist zwischen dem zylindrischen Bereich 11 des Deckels 1 und dem Absatz 4 eingespannt. Hierzu sind die Abmessungen so zu wählen, daß der zwischen dem Bereich 11 und dem Absatz 4 bestehende Spalt schmaler ist als der Durchmesser, den Ring 61 aufweist, wenn auf diesen keine Kraft einwirkt.

Da die Dichtwirkung bereits in diesem Stadium eintritt, ist eine Mindestdichtheit des Gehäuses auch dann gegeben, wenn ein Anwender den Deckel 1 nicht, wie zum vollständigen Schließen des Gehäuses erforderlich, ausreichend dreht.

Die Drehbewegung des Deckels 1 wird durch die Sickenpaare geführt. Die Sicken 3 gleiten zwischen den ersten und zweiten Sicken 51, 52 entlang. Die Sickenpaare erfüllen die Funktion eines Gewindegangabschnitts.

Da alle Sicken 3, 51, 52 gegenüber einer Senkrechten auf die Längsachse des Gehäuses geneigt sind, wird der Deckel 1 durch die Drehung relativ zu dem Gehäusetopf 2 parallel zu dessen Längsachse verschoben.

Damit der Deckel 1 bei dieser Drehung in gehäusetopf-zugewandter Richtung bewegt wird, ist der Winkel α, den die Sicken 51, 52 mit der Senkrechten auf die Langsachse des Gehäusetopfs 2 einschließen so zu wählen, daß das an den unbedeckten Abschnitt 53 angrenzende Ende der ersten Sicke 51 in axialer Richtung weiter von dem Abschnitt 22 des Gehäusetopf 2 entfernt ist als das vom Abschnitt 53 abgewandte Ende der selben Sicke 51. Die Winkel α der in dem Deckel 1 angeordneten Sicken 3 und die Winkel α der an dem Gehäusetopf 2 angeordneten Sicken 51, 52 sind gleich.

In dem in Fig. 3 dargestellte Ausführungsbeispiel weist der Gehäusetopf 2 auf der dem ersten Abschnitt 21 zugewandten Seite der konischen Mantelfläche 41 eine umlaufende Nut 42 auf, deren Form an die Form des Rings 61 der Dichtung 6 angepaßt ist. Hierdurch wird die bereits durch den Durchmesser der Dichtung 6 hergestellte Fixierung derselben verstärkt.

Durch die Bewegung des Deckels 1 in axialer, gehäusetopf-zugewandter Richtung übt der Deckel 1 eine Kraft auf die Dichtung 6 aus. Wie in Fig. 3 dargestellt, liegt die Dichtung 6 auf dem Absatz 4 und ist bei geschlossenem Deckel 1 zwischen diesem und dem Absatz 4 in, auf die Längsachse des ersten Abschnitts bezogen, radialer Richtung eingespannt. Die Nut 42 bietet beim Schließen des Deckels 1 einen zusätzlichen Halt für den Ring 61 der Dichtung 6.

Der zylindrische Bereich 11 des Deckels 1 ist endseitig abgeschrägt und liegt mit einer ringförmigen Stirnfläche 14 auf der Ringscheibe 62 der Dichtung 6. Durch die Bewegung des Deckels 1 in axialer gehäusetopf-zugewandter Richtung wird die Ringscheibe 62 in axialer Richtung zwischen der Stirnfläche 14 und dem Absatz 4 eingespannt. Es liegt somit neben der durch den Ring 61 bewirkten Radialdichtung zusätzlich eine Axialdichtung vor. Weiterhin wird der Spalt zwischen dem Deckel 1 und dem Gehäusetopf 2 durch die Ringscheibe 62 endseitig verschlossen. Damit ist Ansatzbildung an dieser hierfür kritischen Stelle ausgeschlossen. Es kann kein Ansatz oder Schmutz in den Spalt eindringen.

Die Außenwände des Gehäuses sind glatt. Es gibt keine Hinterschneidungen, in denen sich Ansatz ablagern könnte.

Der Winkel α, den die Sicken 3, 51, 52 mit der Senkrechten auf die Längsachse des Deckels 1 bzw. des Gehäusetopfes 2 einschließen ist vorzugsweise kleiner oder gleich 7°. Dadurch wird erreicht, daß der Deckel 1 nur durch eine äußere Krafteinwirkung lösbar ist. Dies wird zusätzlich unterstützt durch die Haftreibung die zwischen der Dichtung 6 und dem Deckel 1 und zwischen der Dichtung 6 und dem Gehäusetopf 2 besteht. Hierdurch ist die Dichtheit des Gehäuses auch dann noch sichergestellt, wenn das Gehäuse in einer Umgebung eingesetzt wird, in der es über einen sehr langen Zeitraum starken Vibrationen ausgesetzt ist. Dies ist beispielsweise erforderlich, wenn es an einem Lebensmittelbehälter in der Nähe von großen Pumpen oder Rührwerken eingesetzt wird.

Die Ringscheibe 62 der Dichtung 6 steht in Kontakt mit der Umgebung. Die Dichtung 6 kann jederzeit problemlos ausgewechselt werden, indem der Deckel 1 abgenommen und anschließen wieder geschlossen wird. Dieser Vorgang ist beliebig oft wiederholbar, ohne daß die Dichtheit des Gehäuses hierdurch beinträchtigt wird.

Zum Lösen des Deckels 1 ist dieser zu drehen. Diese Drehbewegung wird ebenfalls durch die Sickenpaare geführt. Dies ist besonders dann vorteilhaft, wenn die Dichtung 6 bedingt durch Umwelteinflüsse an dem Deckel 1 und/oder an dem Gehäusetopf 2 klebt. Eine solche Verklebung ist durch eine aus einer Drehbewegung resultierenden Kraft sehr viel einfacher zu lösen als durch eine in axialer Richtung einwirkende Kraft.

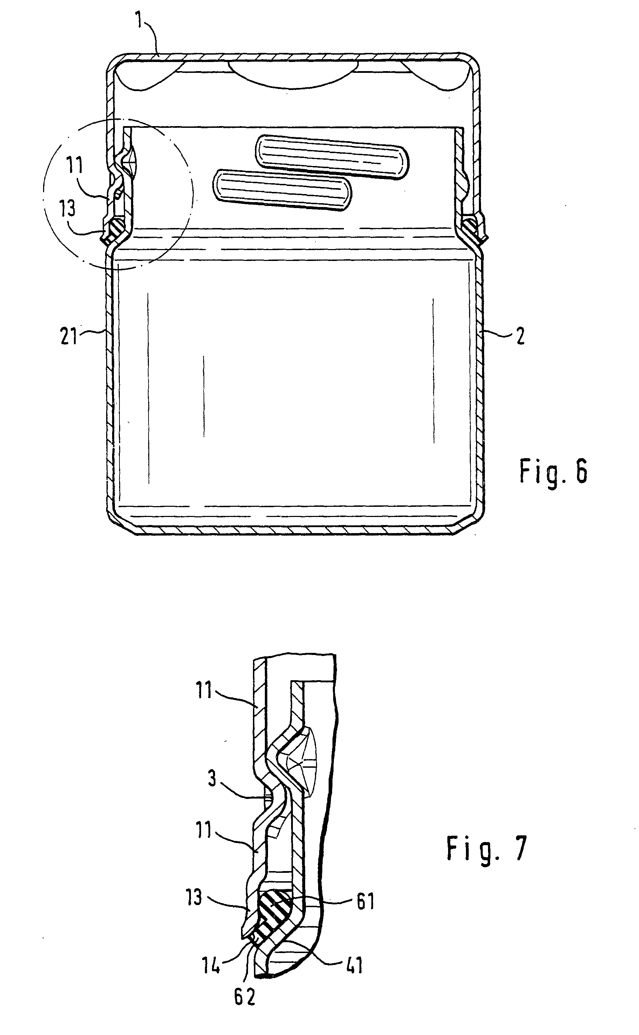

In den Figuren 6 und 7 ist ein zweites Ausführungsbeispiel dargestellt. Es werden daher nachfolgend lediglich die Unterschiede zu dem ersten Ausführungsbeispiel näher erläutert.

Bei beiden Ausführungsbeispielen weist der Absatz 4 eine konische Mantelfläche 41 auf, auf dem die Dichtung 6 mit deren Ringscheibe 61 aufliegt. Bei dem zweiten Ausführungsbeispiel ist jedoch keine Nut zur Aufnahme der Dichtung 6 vorgesehen. Stattdessen weist der Deckel 1 an dessen gehäusetopf-zugewandten Seite einen Bereich 13 mit einem Durchmesser auf, der geringfügig größer als der Durchmesser des daran anschließenden zylindrischen Bereichs 11 des Deckels 1 ist. Die Höhe dieses Bereichs, d.h. dessen Ausdehnung in axialer Richtung ist geringfügig größer als der Durchmesser des Rings 61 der Dichtung 6. Der Bereich 13 verleiht dem Deckel 1 eine zusätzliche Stabilität gegenüber Verformungen. Der Bereich 13 liegt mit einer ringförmigen Stirnfläche 14 auf der Ringscheibe 62 der Dichtung 6.

Selbstverständlich kann sowohl an dem Deckel 1 als auch an dem Gehäusetopf 2 eine Anschlußvorrichtung angeordnet sein, durch die z.B. elektrische Leitungen in das Gehäuse geführt werden können oder ein Sensor an eine in dem Gehäuse angeordnete Elektronik angeschlossen werden kann.

Der Deckel 1 und der Gehäusetopf 2 sind Bauteile die aufgrund ihrer speziellen Form durch Umformtechnik, z.B. aus einem Edelstahlblech, herstellbar sind. Die im Deckel 1 anzuordenden Sicken 3 und die im ersten Abschnitt 21 des Gehäusetopf 2 anzubringenden Sicken 51, 52 werden eingeprägt. Dies Herstellverfahren ist einsetzbar, da die Sicken 3, 51, 52 dem Deckel 1 und dem Gehäusetopf 2 eine zusätzliche mechanische Stabilität verleihen. Hierdurch ist eine Wandstärke von z.B. 1, 2 mm bereits ausreichend.

Demgegenüber weisen Gehäuse bei denen der Deckel mittels eines Gewindes aufzuschrauben ist eine Wandstärke von etwa 4 mm auf. Ein Gewinde reduziert die Stabilität eines Gehäuses. Bauteile mit einer Wandstärke von 4 mm können nicht durch Umformtechnik hergestellt werden, sondern müssen z.B. als Guß oder Drehteil hergestellt werden. Die Umformtechnik ist das kostengünstigere Herstellverfahren.

Auch bietet die Umformtechnik den Vorteil, das nachträglich problemlos weitere Teile an das Gehäuse angeschweißt werden können.

Die Form des zweiten Abschnitts 22 ist bei Verwendung von Umformtechnik in sehr weiten Grenzen frei wählbar und nicht auf die dargestellt zylindrische Form beschränkt.

Gleichwertig zu der in den Ausführungsbeispielen dargestellten Anordnung der einzelnen Sicken 3 im Deckel 1 und der Sickenpaare in dem ersten Abschnitt 21 des Gehäusetopfes 2 ist eine hierzu komplimentäre Anordnung. Bei dieser sind an dem ersten Abschnitt mindestens drei nach außen gewölbte Sicken angeordnet, die gegenüber einer Senkrechten auf die Längsachse des Gehäusetopfs um einen spitzen Winkel geneigt sind. Am zylindrischen Abschnitt des Deckels sind mindestens drei Sickenpaare angeordnet, die jeweils eine erste und eine zweiten in das Innere des Deckles gewölbte Sicke aufweisen. Die erste Sicke ist jeweils parallel zu der zweiten Sicke angeordnet und beide sind gegenüber einer Senkrechten auf die Längsachse des Deckels um einen spitzen Winkel geneigt. Bei geschlossenem Deckel befindet sich jede an den ersten Abschnitt angeformte Sicke zwischen einer ersten und einer zweiten Sicke eines im Deckel angeordneten Sickenpaares.

Die Anordnung der Dichtung zwischen dem Deckel 1 und dem Gehäusetopf ist identisch zu der in den Ausführungsbeipielen dargestellten.

## Patentansprüche

1. Gehäuse für industrielle Anwendungen
- mit einem Gehäusetopf (2),
-- der einen zylindrischen ersten Abschnitt (21) aufweist,
--- an dem mindestens drei Sickenpaare angeordnet sind,
---- die jeweils eine erste und eine zweite nach außen gewölbte Sicke (51, 52) aufweisen,
---- wobei die erste Sicke (51) jeweils parallel zu der zweiten Sicke (52) angeordnet ist und
---- wobei jeweils die erste und die zweite Sicke (51, 52) gegenüber einer Senkrechten auf die Längsachse des ersten Abschnitts (21) um einen spitzen Winkel (α) geneigt sind, und
-- der einen an den ersten Abschnitt (21) angrenzenden Absatz (4) aufweist, der einen an den Absatz (4) angrenzen den zweiten Abschnitt (22) aufweist,
- mit einem abnehmbaren topfartigen Deckel (1)
-- der einen zylindrischen Bereich (11) aufweist,
--- der den ersten Abschnitt (21) des Gehäusetopfes (2) umgreift und
--- auf dem mindestens drei in das Innere des Deckels (1) gewölbte Sicken (3) angeordnet sind,
---- die gegenüber einer Senkrechten auf die Längsachse des Deckels (1) um einen spitzen Winkel (α) geneigt sind und
---- die bei geschlossenem Deckel (1) jeweils zwischen den ersten und zweiten Sicken (51, 52) der Sickenpaare angeordnet sind, und
- mit einer ringförmigen Dichtung (6),
-- die auf dem zwischen dem ersten und dem zweiten Abschnitt (21, 22) angeordneten Absatz (4) liegt, und
-- die bei geschlossenem Deckel (1) durch diesen und den Absatz (4) in radialer Richtung eingespannt ist.

2. Gehäuse für industrielle Anwendungen
- mit einem Gehäusetopf,
-- der einen zylindrischen ersten Abschnitt aufweist,
-- an dem mindestens drei nach außen gewölbte Sicken angeordnet sind,
--- die gegenüber einer Senkrechten auf die Längsachse des Gehäusetopfs um einen spitzen Winkel geneigt sind, und
-- der einen an den ersten Abschnitt angrenzenden Absatz aufweist, der einen an den Absatz angrenzenden zweiten Abschnitt aufweist,
- mit einem abnehmbaren topfartigen Deckel
-- der einen zylindrischen Bereich aufweist,
--- der den ersten Abschnitt des Gehäusetopfes umgreift und
--- auf dem mindestens drei Sickenpaare angeordnet sind,
---- die jeweils eine erste und eine zweite in das Innere des Deckels gewölbte Sicke aufweisen,
---- wobei die erste Sicke jeweils parallel zur zweiten Sicke angeordnet ist und
--- wobei jeweils die ersten und die zweiten Sicken gegenüber einer Senkrechten auf die Längsachse des Deckels um einen spitzen Winkel geneigt sind,und
--- wobei die an den ersten Abschnitt angeformten Sicken bei geschlossenem Deckel zwischen ersten und zweiten Sicken der Sickenpaare angeordnet sind, und
- mit einer ringförmigen Dichtung,
-- die auf dem zwischen dem ersten und dem zweiten Abschnitt angeordneten Absatz liegt und
-- die bei geschlossenem Deckel durch diesen und den Absatz in radialer Richtung eingespannt ist.

3. Gehäuse nach Anspruch 1 oder 2, bei dem der Absatz (4) eine an den zweiten Abschnitt (22) des Gehäusetopfes (2) angrenzende Mantelfläche (41) und eine umlaufende an den ersten Abschnitt (21) angrenzende Nut (42) aufweist.

4. Gehäuse nach Anspruch 1 oder 2, bei dem der Absatz (4) eine zwischen dem ersten und dem zweiten Abschnitt (21, 22) des Gehäusetopfes angeordnete Mantelfläche (41) aufweist und bei dem der Deckel (1) an dessen gehäusetopf-zugewandter Seite einen Bereich (13) mit einem Durchmesser aufweist, der geringfügig größer als der Durchmesser des daran anschließenden Abschnitts des Deckels ist.

5. Gehäuse nach Anspruch 1 oder 2, bei dem die Dichtung (6) eine Formdichtung ist, die
- einen Ring (61) mit ringförmigem Querschnitt und
- eine daran angeformte Ringscheibe (62) mit rechteckigen Querschnitt aufweist, und bei dem
- die Ringscheibe (62) mit einer Ringfläche auf dem Absatz (4) liegt.

6. Gehäuse nach Anspruch 5, bei dem der Deckel (1) mit einer ringförmigen Stirnfläche (14) auf einer gehäusetopf-abgewandten Ringfläche der Ringscheibe (62) aufliegt.

7. Gehäuse nach Anspruch 1 oder 2, bei dem die spitzen Winkel (α) kleiner oder gleich 7° sind.

8. Gehäuse nach Anspruch 1 oder 2, bei dem die Sicken (3, 51, 52) spitzwinklige Kreisringsegmente sind und bei dem die Sicken (51, 52) eines Sickenpaares die gleiche Länge aufweisen und zueinander parallel und gegeneinander parallel zu deren Längsachse versetzt angeordnet sind.

9. Gehäuses nach Anspruch 1 oder 2, in dem eine Elektronik eines Meßgeräts angeordnet ist.

10. Gehäuses nach Anspruch 1 oder 2, das mittels Umformtechnik, insb. aus einem Edelstahlblech, hergestellt ist.

## Claims

1. A casing for industrial applications
- comprising a casing pot (2)
- - having a cylindrical first portion (21)
- - - on which at least three pairs of beads are arranged,
- - - - each pair comprising a first and a second outwardly curved bead (51, 52),
- - - - wherein in each case the first bead (51) is arranged parallel to the second bead (52) and
- - - - wherein the first and the second bead (51, 52) are in each case inclined at an acute angle (α) to a line perpendicular to the longitudinal axis of the first portion (21), and
- - having a shoulder (4) adjoining the first portion (21) and a second portion (22) adjoining the shoulder (4),
- comprising a removable, pot-like cover (1)
-- having a cylindrical region (11)
--- which engages over the first portion (21) of the casing pot (2) and
--- on which at least three beads (3) curving into the interior of the cover (1) are arranged
---- which are inclined at an acute angle (α) to a line perpendicular to the longitudinal axis of the cover (1) and
---- which are each arranged between the first and second beads (51, 52) of the pairs of beads when the cover (1) is closed, and
- comprising an annular seal (6)
-- resting on the shoulder (4) arranged between the first and the second portion (21, 22) and
-- radially clamped by the cover (1) and the shoulder (4) when the cover (1) is closed.

2. A casing for industrial applications
- comprising a casing pot
- - having a cylindrical first portion
- - on which at least three outwardly curved beads are arranged
- - - which are inclined at an acute angle to a line perpendicular to the longitudinal axis of the casing pot, and
- - having a shoulder adjoining the first portion and a second portion adjoining the shoulder,
- comprising a removable, pot-like cover
-- having a cylindrical region
--- which engages over the first portion of the casing pot and
--- on which at least three pairs of beads are arranged,
---- each pair comprising a first and a second bead curving into the interior of the cover,
---- wherein in each case the first bead is arranged parallel to the second bead and
---- wherein the first and the second beads are in each case inclined at an acute angle to a line perpendicular to the longitudinal axis of the cover and
---- wherein the beads formed on the first portion are arranged between first and second beads of the pairs of beads when the cover is closed, and
- comprising an annular seal
-- resting on the shoulder arranged between the first and the second portion and
-- radially clamped by the cover and the shoulder when the cover is closed.

3. A casing according to claim 1 or 2, wherein the shoulder (4) has an outer surface (41) adjoining the second portion (22) of the casing pot (2) and a circumferential groove (42) adjoining the first portion (21).

4. A casing according to claim 1 or 2, wherein the shoulder (4) has an outer surface (41) arranged between the first and the second portion (21, 22) of the casing pot and wherein the cover (1), at its end facing the casing pot, has a region (13) with a diameter slightly greater than the diameter of the adjoining portion of the cover.

5. A casing according to claim 1 or 2, wherein the seal (6) is a moulded seal comprising
- a ring (61) with a ring-shaped cross-section and
- an annular disc (62) formed thereon with a rectangular crosssection, and wherein
- the annular disc (62) rests with an annular surface on the shoulder (4).

6. A casing according to claim 5, wherein the cover (1) rests with a ring-shaped end surface (14) on an annular surface - remote from the casing pot - of the annular disc (62).

7. A casing according to claim 1 or 2, wherein the acute angle (α) is smaller than or equal to 7°.

8. A casing according to claim 1 or 2, wherein the beads (3, 51, 52) are acute-angled ring segments and wherein the beads (51, 52) of a pair of beads are the same length and arranged so as to be mutually parallel and so as to be mutually offset parallel to their longitudinal axis.

9. A casing according to claim 1 or 2, in which an electronic system of a measuring device is arranged.

10. A casing according to claim 1 or 2, manufactured by metal working, in particular from a stainless steel sheet.

## Revendications

1. Boîtier pour des applications industrielles
- avec un pot de boîtier (2),
-- qui présente une première section cylindrique (21),
--- sur laquelle sont situées au moins trois paires de moulures,
---- qui présentent respectivement une première et une deuxième moulures bombées vers l'extérieur (51, 52),
---- la première moulure (51) étant respectivement disposée parallèlement à la deuxième moulure (52) et
---- la première et la deuxième moulures (51, 52) étant respectivement inclinées d'un angle de pointe (α) par rapport à une perpendiculaire sur l'axe longitudinal de la première section (21), et
-- qui présente un segment (4) contigu à la première section (21),
-- qui présente une deuxième section (22) contiguë au segment (4),
- avec un couvercle amovible (1) semblable à un pot,
-- qui présente une zone cylindrique (11),
--- qui enveloppe la première section (21) du pot de boîtier (2) et
--- sur lequel sont situées au moins trois moulures (3) bombées à l'intérieur du couvercle (1),
---- qui sont inclinées d'un angle de pointe (α) par rapport à une perpendiculaire sur l'axe longitudinal du couvercle (1) et
---- qui, lorsque le couvercle (1) est fermé, sont respectivement disposées entre la première et la deuxième moulures (51, 52) des paires de moulures, et
- avec un joint en forme d'anneau (6),
-- qui repose sur le segment (4) situé entre la première et la deuxième sections (21, 22), et
-- qui, lorsque le couvercle (1) est fermé, est enserré en direction radiale par celui-ci et le segment (4).

2. Boîtier pour des applications industrielles
- avec un pot de boîtier,
-- qui présente une première section cylindrique,
-- sur laquelle sont situées au moins trois moulures bombées vers l'extérieur,
--- qui sont inclinées d'un angle de pointe par rapport à une perpendiculaire sur l'axe longitudinal du pot de boîtier, et
-- qui présente un segment contigu à la première section,
-- qui présente une deuxième section contiguë au segment,
- avec un couvercle amovible semblable à un pot,
-- qui présente une zone cylindrique,
--- qui enveloppe la première section du pot de boîtier et
--- sur lequel sont situées au moins trois paires de moulures,
---- qui présentent respectivement une première et une deuxième moulures bombées à l'intérieur du couvercle,
---- la première moulure étant respectivement disposée parallèlement à la deuxième moulure et
--- la première et la deuxième moulures étant respectivement inclinées d'un angle de pointe par rapport à une perpendiculaire sur l'axe longitudinal du couvercle, et
--- les moulures formées au niveau de la première section étant disposées entre la première et la deuxième moulure des paires de moulures lorsque le couvercle est fermé, et
- avec un joint en forme d'anneau,
-- qui repose sur le segment situé entre la première et la deuxième sections et
-- qui, lorsque le couvercle est fermé, est enserré en direction radiale par celui-ci et le segment.

3. Boîtier conformément à la revendication 1 ou 2, dans lequel le segment (4) présente une surface d'enveloppe (41) contiguë à la deuxième section (22) du pot de boîtier (2) ainsi qu'une rainure (42) tournante contiguë à la première section (21).

4. Boîtier conformément à la revendication 1 ou 2, dans lequel le segment (4) présente une surface d'enveloppe (41) située entre la première et la deuxième sections (21, 22) du pot de boîtier et dans lequel le couvercle (1) présente, au niveau de sa face tournée vers le pot de boîtier, une zone (13) avec un diamètre qui est légèrement supérieur au diamètre de la section du boîtier qui s'y rattache.

5. Boîtier conformément à la revendication 1 ou 2, dans lequel le joint (6) est un joint profilé qui
- présente un anneau (61) avec une section en forme d'anneau et
- un disque annulaire (62) formé à ce niveau avec une section rectangulaire, et dans lequel
- le disque annulaire (62) repose avec une surface annulaire sur le segment (4).

6. Boîtier conformément à la revendication 5, dans lequel le couvercle (1) s'appuie avec une surface extérieure en forme d'anneau (14) sur une surface annulaire du disque annulaire (62), tournée vers le pot de boîtier.

7. Boîtier conformément à la revendication 1 ou 2, dans lequel les angles de pointe (α) sont inférieurs ou égaux à 7°.

8. Boîtier conformément à la revendication 1 ou 2, dans lequel les moulures (3, 51, 52) sont des segments d'anneaux de cercles acutangulés et dans lequel les moulures (51, 52) d'une paire de moulures présentent la même longueur et sont disposées parallèlement l'une à l'autre et décalées l'une par rapport à l'autre parallèlement à leur axe longitudinal.

9. Boîtier conformément à la revendication 1 ou 2, dans lequel est placée l'électronique d'un appareil de mesure.

10. Boîtier conformément à la revendication 1 ou 2, qui est fabriqué au moyen de la technique de formage, notamment à partir d'une tôle d'acier spécial.
